# EUROPÄISCHE PATENTANMELDUNG

(11) **EP 1 072 851 A1**
(43) Veröffentlichungstag der Anmeldung: **31.01.2001**
(21) Anmeldenummer: 99114852.9
(22) Anmeldetag: 29.07.1999
(51) Int. Cl.: F25B 9/14, H01F 6/04

(54) **Kühlvorrichtung**

(71) Anmelder: CSP Cryogenic Spectrometers GmbH, 85737 Ismaning (DE)
(72) Erfinder: Bühler, Matthias, Dr., 82140, Olching (DE); Hertrich, Theo, Dr., 85737, Ismaning (DE); Höhne, Jens, Dr., 81667, München (DE)
(74) Vertreter: Winter, Brandl & Partner

(57) **Zusammenfassung**

Offenbart ist eine Kühlvorrichtung, die aufweist einen ersten Pulsröhrenkühler mit einem ersten Pulsrohr 20, das eine Länge L_{P1} hat und einen Warmkopf 22 mit einer ersten Temperatur T_{A1}, sowie einen Kaltkopf 24 mit einer bezüglich der ersten Temperatur tieferen zweiten Temperatur T_{E} aufweist, und mit einem ersten Regenerator 40, der eine Länge L_{R1} hat und einen warmen Endabschnitt 44, sowie einen kalten Endabschnitt 46, welcher mit dem Kaltkopf des ersten Pulsrohrs verbunden ist, aufweist; und ein zu kühlendes Objekt 82, das über eine Wärmeübertragungseinrichtung 85 an den Kaltkopf des ersten Pulsrohrs thermisch gekoppelt ist. Erfindungsgemäß ist das zu kühlende Objekt dabei neben und zumindest teilweise innerhalb der Länge L_{P1} des ersten Pulsrohrs und/oder der Länge L_{R1} des ersten Regenerators angeordnet. Aufgrund dieser Anordnung läßt sich eine Kühlvorrichtung ausbilden, deren Abmessung insbesondere in axialer Richtung minimiert ist.

## Beschreibung

### Technisches Gebiet

Die Erfindung betrifft eine Kühlvorrichtung gemäß Anspruch 1.

Derartige Kühlvorrichtung haben aufgrund ihrer Verwendung eines oder mehrerer Pulsröhrenkühler einen breiten Einsatzbereich und werden vorzugsweise als mobile Kühlvorrichtungen verwendet, die ein Kühlen auf tiefe bzw. sehr tiefe Temperaturen an beliebigen Orten gestatten. Eine erfindungsgemäße Kühlvorrichtung eignet sich somit beispielsweise zur Kühlung von Bauelementen aus Hochtemperatursupraleitern, wie SQUIDs, zur Kühlung von Halbleiterbauelementen, wie Infrarotdetektoren oder Hochgeschwindigkeitsschaltkreise für eine sehr schnelle Datenverarbeitung, oder auch zur Kühlung von Sensoren, die auf einem Tieftemperatureffekt basieren.

### Stand der Technik

Aus C. Wang et al.:"Cryogen Free Operation of a Niobium-Tin Magnet using a Two-stage Pulse tube cooler", in den Proceedings zur Konferenz "Applied Superconductivity", 1998 in Palm Desert ist eine in einem Kryostaten untergebrachte Vorrichtung zum Kühlen eines supraleitenden Magnetsystems bekannt, die ein zweistufiges hintereinander geschaltetes Pulsröhrenkühlersystem verwendet. Jeweilige erste und zweite Pulsrohre bzw. erste und zweite Regeneratoren, die alle im wesentlichen parallel zueinander angeordnet sind, sind an ihren Warmköpfen bzw. warmen Endabschnitten mit einer Kryostatenabdeckung verbunden. Der 54K-Kaltkopf des zweiten, kürzeren Pulsrohrs ist mit einem Wärmeschild verbunden, in dem der untere, kalte Abschnitt des ersten Pulsrohrs bzw. ersten Regenerator angeordnet sind. Am unteren Ende des 4K-Kaltkopfs des ersten Pulsrohrs ist ferner das zu kühlende Magnetsystem angebracht, das über von der Kryostatenabdeckung eingebrachte elektrische Leitungen mit Strom versorgt wird.

Als nachteilig bei der oben erwähnten Kühlvorrichtung stellt sich heraus, daß aufgrund der Anordnung des zu kühlenden Magnetsystems am unteren Ende des Kaltkopfs des ersten Pulsrohrs die gesamte Kühlvorrichtung, insbesondere in axialer Richtung ausgehend von der Achse der ersten Pulsrohrs, räumlich sehr ausgedehnt ist, was zu einem großen vorrichtungstechnischem Aufwand und einer eingeschränkten Mobilität führt.

### Darstellung der Erfindung

Es ist nun eine Aufgabe der vorliegenden Erfindung, eine Kühlvorrichtung mit einem Pulsröhrenkühler zum Kühlen eines Objekts zu schaffen, die bei kompaktem Aufbau eine hohe Kühlleistung aufweist.

Diese Aufgabe wird durch eine Kühlvorrichtung gemäß der Merkmale des Anspruchs 1 gelöst. Vorteilhafte Ausgestaltungen sind Gegenstand der Unteransprüche.

Die erfindungsgemäße Kühlvorrichtung umfaßt einen ersten Pulsröhrenkühler mit einem ersten Pulsrohr, das eine Länge L_{P1} hat und einen Warmkopf mit einer ersten Temperatur T_{A1}, sowie einen Kaltkopf mit einer bezüglich der ersten Temperatur tieferen zweiten Temperatur T_{E} aufweist, und mit einem ersten Regenerator, der eine Länge L_{R1} hat und einen warmen Endabschnitt, sowie einen kalten Endabschnitt, welcher mit dem Kaltkopf des ersten Pulsrohrs verbunden ist, aufweist; und ein zu kühlendes Objekt, das über eine Wärmeübertragungseinrichtung an den Kaltkopf des ersten Pulsrohrs thermisch gekoppelt ist. Erfindungsgemäß ist das zu kühlende Objekt dabei neben und zumindest teilweise innerhalb der Länge L_{P1} des ersten Pulsrohrs und/oder der Länge L_{R1} des ersten Regenerators angeordnet. Es ist ferner, denkbar das gesamte zu kühlende Objekt neben und innerhalb der Länge L_{P1} des ersten Pulsrohrs und/oder der Länge L_{R1} des ersten Regenerators anzuordnen.

Durch diese Maßnahme kann der "Kühlraum" der Kühlvorrichtung, der vorteilhafterweise von einem Kryostaten umgeben ist, wirksam ausgenutzt werden, d.h. Zwischenräume zwischen einzelnen Pulsrohr- oder Regeneratorkomponenten werden minimiert. Dadurch wird insbesondere in axialer Richtung, vor allem bezüglich der Achse des ersten Pulsrohrs, das in einem herkömmlichen Pulsröhrenkühler die längste Abmessung hat, eine Verkleinerung herbei geführt.

Im Gegensatz zum Stand der Technik jedoch, bei dem die Aufhängung des zu kühlenden Objekts am Kaltkopf des ersten Pulsrohrs mehr oder weniger symmetrisch beispielsweise über Fäden in Schwerkraftrichtung erfolgte, sind im Fall der vorliegenden Erfindung Probleme aufgrund der asymmetrischen bzw. azentrischen Belastung (wenn das zu kühlende Objekt beispielsweise neben und an dem ersten Pulsrohr angebracht ist) zu berücksichtigen. Das Halten von leichteren zu kühlenden Objekten kann durch eine verbesserte bzw. verstärkte mechanische Struktur des Kaltkopfs des ersten Pulsrohrs bzw. des gesamten Pulsrohrs erreicht werden. Hierbei kann beispielsweise eine Platte mit der Funktion einer Wärmeübertragungseinrichtung und einer Halteeinrichtung am Kaltkopf des ersten Pulsrohrs derart angebracht werden, daß sie sich senkrecht bezüglich der Achse des ersten Pulsrohrs erstreckt. Auf der Platte und neben dem ersten Pulsrohr wird dann das zu kühlende Objekt in thermischem Kontakt zur Platte und somit zum ersten Kaltkopf angeordnet.

Bei schwereren zu kühlenden Objekten ist es vorteilhaft, noch eine zusätzliche Befestigungseinrichtung zum Halten des zu kühlenden Objekts vorzusehen. Diese Befestigungseinrichtung hat ein erstes Ende, das mit dem zu kühlenden Objekt verbunden ist, und ein zweites Ende, das mit einem Bereich, der eine bezüglich der zweiten Temperatur T_{E}, d.h. des ersten Kaltkopfs, höhere Temperatur T_{V} aufweist, verbunden ist. Somit können aufgrund der zusätzlichen Tragestruktur schwerere Objekte bei kompaktem Aufbau gekühlt werden, es können aber auch leichtere Objekte ohne bzw. ohne großer Veränderung der mechanischen Struktur, beispielsweise des ersten Pulsrohrs, gekühlt werden. Der oben erwähnte Bereich, der allgemein ein Gebiet oder eine Einrichtung, wie beispielsweise eine Kryostatenabdeckung, mit einer höheren Temperatur als T_{E} bezeichnet, kann dabei von einer Anschlußeinrichtung für die Befestigungseinrichtung gebildet werden oder mit dieser in thermischem Kontakt stehen. Eine derartige Anschlußeinrichtung kann ferner ein mechanisches Befestigungsmittel, wie beispielsweise ein Klebemittel oder eine Verschraubung, oder auch einen elektrischen Anschluß aufweisen.

Gemäß einer vorteilhaften Ausgestaltung der Befestigungseinrichtung verläuft diese zumindest teilweise in thermischem Kontakt mit dem ersten Pulsrohr und/oder teilweise in thermischem Kontakt mit dem ersten Regenerator. Durch diese Maßnahme wird bewirkt, daß die Befestigungseinrichtung schon vor dem Kontakt mit dem zu kühlenden Objekt bzw. dem Kaltkopf des ersten Pulsrohrs durch den teilweisen thermischen Kontakt mit dem ersten Pulsrohr und/oder durch den teilweisen thermischen Kontakt mit dem ersten Regenerator vorgekühlt wird. Insbesondere beim (teilweisen) entlang Führen der Befestigungseinrichtung vom Warmkopf zum Kaltkopf bzw. vom warmen Endabschnitt zum kalten Endabschnitt wird aufgrund des Wärme- oder Temperaturgradienten zwischen dem Warmkopf und Kaltkopf des (ersten bzw. zweiten) Pulsrohrs somit die Temperatur der an einer oder mehreren Stellen mit dem Pulsrohr oder Regenerator in thermischen Kontakt stehenden Befestigungseinrichtung an verschiedenen Temperaturniveaus "abgefangen" bzw. angeglichen.

Bei Verwendung eines zweiten Pulsröhrenkühlers, wie es gemäß einer vorteilhaften Ausgestaltung der Erfindung unten beschrieben werden wird, kann die Befestigungseinrichtung zumindest teilweise in thermischem Kontakt mit dem zweiten Pulsrohr und/oder in thermischem Kontakt mit dem zweiten Regenerator verlaufen.

Gemäß einer weiteren vorteilhaften Ausgestaltung der Befestigungseinrichtung weist diese einen zweiteiligen Aufbau auf. Ein erster Teil bzw. Halteteil besteht dabei vorzugsweise aus einem schlecht wärmeleitendem Material, wie Kunststoff, und dient zum eigentlichen Halten des zu kühlenden Objekts an einer Anschlußeinrichtung. Eine zweiter Teil bzw. Kontaktteil besteht vorzugsweise aus einem gut leitenden Material, wie Metall, und dient zum thermischen in Kontakt bringen der Halteeinrichtung mit einem (ersten bzw. zweiten) Pulsrohr und/oder (ersten bzw. zweiten) Regenerator, und damit zum Vorkühlen der gesamten Halteeinrichtung.

Gemäß einer vorteilhaften Ausgestaltung der Kühlvorrichtung, insbesondere zum Erzielen eines kompakten Aufbaus, sind das erste Pulsrohr und der erste Regenerator im wesentlichen parallel zueinander angeordnet. Dabei kann die Kühlleistung dadurch optimiert werden, daß das erste Pulsrohr und der erste Regenerator im wesentlichen vertikal in Richtung des Erdschwerkraftgradienten angeordnet sind.

Zum wirksamen Entgegenwirken der Wärmelast am ersten Pulsrohrkaltkopf bzw. zur Verbesserung der Kühlleistung des mit dem zu kühlenden Objekt verbundenen ersten Pulsrohrkaltkopfs und damit auch zum Absenken der Kühltemperatur kann ein zweiter Pulsröhrenkühler verwendet werden. Dieser hat ein zweites Pulsrohr, das eine im Verhältnis zur Länge L_{P1} des ersten Pulsrohrs kleinere Länge L_{P2}, sowie einen Warmkopf mit einer dritten Temperatur T_{A2} und einen Kaltkopf mit einer bezüglich der dritten Temperatur T_{A2} tieferen vierten Temperatur T_{Z}, die zwischen der ersten Temperatur T_{A1} und der zweiten Temperatur T_{E} liegt, aufweist, und einen zweiten Regenerator, der eine im Verhältnis zur Länge L_{R1} des ersten Regenerators kleineren Länge L_{R2}, sowie einen warmen Endabschnitt und einen kalten Endabschnitt, welcher mit dem Kaltkopf des zweiten Pulsrohrs verbunden ist, aufweist, wobei an dem zweiten Pulsrohr die vierte Temperatur zum Vorkühlen des ersten Pulsröhrenkühlers bereitgestellt wird.

Gemäß einer weiteren vorteilhaften Ausgestaltung der Kühlvorrichtung, insbesondere zum Erzielen eines Kompakten Aufbaus, sind das zweite Pulsrohr und der zweite Regenerator im wesentlichen parallel zueinander angeordnet. Dabei kann die Kühlleistung dadurch optimiert werden, daß das zweite Pulsrohr und der zweite Regenerator im wesentlichen vertikal in Richtung des Erdschwerkraftgradienten angeordnet sind.

Ein besonders vorteilhafter und kompakter Aufbau entsteht dann, wenn das erste Pulsrohr, der erste Regenerator, das zweite Pulsrohr und der zweite Regenerator im wesentlichen parallel zueinander angeordnet sind. Auch bei einem mehrstufigen Kühlsystem mit drei oder mehr Kühlstufen, ist es vorteilhaft, die einzelnen Pulsrohre bzw. Regeneratoren parallel zueinander anzuordnen. Da das zwei oder mehrstufige Pulsröhrenkühlersystem vorteilhafterweise in einem Kryostaten angeordnet und die jeweiligen Warmköpfe bzw. warmen Endabschnitte an einer Kryostatenabdeckung angeordnet sind, kann das zu kühlende Objekt in der Verlängerung der jeweiligen kürzeren Komponenten, d.h. in der Verlängerung des zweiten Pulsrohrs und/oder in der Verlängerung des zweiten Regenerators, angeordnet sein.

Zur weiteren Platzersparnis bzw. zum Erreichen eines kompakten Aufbaus sind der erste und zweite Regenerator nicht als separate Komponenten ausgeführt, sondern der erste Regenerator verwendet den zweiten Regenerator als seinen warmen Endabschnitt mit.

Das von der erfindungsgemäßen Kühlvorrichtung zu kühlende Objekt weist beispielsweise einen auf einem supraleitenden oder normalleitenden Material basierenden Magnet auf, der als Teil einer Entmagnetisierungsstufe (als eine Tieftemperaturkühlvorrichtung) dienen kann. Das zu kühlende Objekt kann ferner einen Sensor zum Erfassen von Teilchen, Strahlung oder Feldern aufweisen. Derartige Sensoren können Sensoren mit einer Betriebstemperatur im Bereich von etwa 30 bis 100 K, wie beispielsweise Silizium-Detektoren (Si(Li)-Dektoren), Germanium-Detektoren (HPGe-Dektoren) oder auf Hochtemperatursupraleitern basierende SQUIDs ("Superconducting Quantum Interference Device", supraleitende Quanten-Interferenz-Vorrichtungen) sein. Das zu kühlende Objekt kann ferner auch Sensoren, die auf einem Tieftemperatureffekt basieren, aufweisen, wobei diese Sensoren aufgrund ihrer Betriebstemperatur kleiner als 20 K, meist sogar kleiner als 4K, von einer Tieftemperaturkühleinrichtung (z.B. einer Entmagnetisierungsstufe), die mit dem Kaltkopf des ersten Pulsrohrs verbunden ist, auf die entsprechende Betriebstemperatur gekühlt werden. Vorteilhafterweise wird bei derartigen Sensoren ein zweistufiges Pulsröhrenkühlsystem verwendet.

Die in der Detektorvorrichtung verwendeten auf einem Tieftemperatureffekt basierende Sensoren, oder auch Kryodetektoren bzw. kryogene Detektoren, sind Sensoren, die durch eine Strahlungs- oder Teilchenabsorption deponierte Energie mittels eines Effektes, der nur oder insbesondere bei tiefen Temperaturen auftritt, messen. Diese Temperaturen werden von einer Wärmesenke bereitgestellt, die an die Detektoreinrichtung, welche einen jeweiligen auf einem Tieftemperatureffekt basierenden Sensor aufweist, thermisch gekoppelt ist. Diese Effekte können sein:
i) Temperaturerhöhung nach Energiedeposition (Kalorimeter) in einem Absorber (Dielektrikum, Metall, Supraleiter, usw.).
ii) Erzeugung von Phononen (Gitterschwingungen in einem Absorbermaterial) durch die Energiedeposition. Je tiefer die Ausgangstemperatur, desto weniger Gitterschwingungen sind vorhanden.
iii) Erzeugung von Quasiteilchen (Aufbrechen von Cooperpaaren) in einem Supraleiter. Supraleitung ist ein Tieftemperatureffekt. Je tiefer die Übergangstemperatur zur Supraleitung, desto mehr dieser Quasiteilchen werden durch die Energiedeposition erzeugt. Je mehr Quasiteilchen erzeugt werden, desto genauer kann die Energie bestimmt werden.
iv) Änderung der Spinausrichtung bzw. Magnetisierung in einem auf tiefe Temperaturen abgekühlten Spinsystem bestehend aus paramagnetischen Ionen aufgrund einer Energiedeposition.

Um die Temperaturerhöhung, die Gitterschwingungen, die Quasiteilchen (allgemein die Anregungen) bzw. die Änderung der Magnetisierung zu messen, gibt es verschiedene Möglichkeiten, wobei generell gilt, daß die Anregungen in einem Absorber erzeugt werden und in einem Sensor nachgewiesen werden. Sensor und Absorber können dabei identisch sein. Als Sensoren kommen in Frage:
a) Supraleitende Phasenübergangsthermometer, wie beispielsweise als Sensor in einem Mikrokalorimeter: Diese bestehen im wesentlichen aus einem Absorber, einem Phasenübergangsthermometer (supraleitende Schicht, beispielsweise aus Wolfram, Iridium, Aluminium oder Tantal) und einer Kühleinrichtung bzw. einer Kopplung an eine Wärmesenke. Im Temperaturübergangsbereich zwischen seiner supraleitenden und normalleitenden Phase ändert das Thermometer seinen elektrischen Widerstand sehr stark in Abhängigkeit von der Temperatur, d.h. auch nach Absorption von Gitterschwingungen und Quasiteilchen.
b) Supraleitende Tunneldioden: Sie bestehen aus zwei überlappenden dünnen supraleitenden Filmen (*SIS*: Supraleiter-Isolator-Supraleiter, wobei die Filme nicht notwendigerweise aus dem gleichen Supraleiter auf beiden Seiten bestehen müssen) oder einem supraleitenden und einem normalleitenden Film (*NIS*: Normalleiter-Isolator-Supraleiter), wobei die jeweiligen Filme durch eine dünne elektrisch isolierende Barriere getrennt sind. Die Barriere ist so dünn, daß sie quantenmechanisches Tunneln von Elektronen, bzw. Quasiteilchen von der einen Elektrode zur anderen erlaubt. Wird die NIS-Diode oder SIS-Diode unterhalb der Sprungtemperatur der jeweiligen Supraleiter betrieben, und ist die angelegte Spannung kleiner als die der supraleitenden Energielücke entsprechenden Spannung (NIS) bzw. kleiner als zweimal diese Spannung (SIS), so steigt der über die Barriere fließende Strom, wenn in der Tunneldiode Energie deponiert wird. Die Deposition der Energie kann durch Temperaturerhöhung, Absorption von Gitterschwingungen oder Quasiteilchen oder direkt durch Absorption von Strahlung oder Teilchen geschehen.
c) Thermistor, wie NTD-Thermometer (*NTD*: "Neutron Transmutation Doping", d.h. mittels Neutronen hochdotierter Halbleiter). Diese Thermometer können zum Messen von Temperaturschwankungen verwendet werden, da bei ihnen, wie bei allen Halbleitern, der Widerstand mit sinkender Temperatur zunimmt. Um zu vermeiden, daß bei sehr tiefen Temperaturen die Widerstände so hoch anwachsen, daß sie nicht mehr mit genügender Genauigkeit gemessen werden können, werden die verwendeten Halbleiter hochdotiert, wodurch ihr Widerstand abgesenkt wird.
d) Magnetische Bolometer. Diese Sensoren, die eine schwache thermische Kopplung an ein Kältebad bzw. eine Wärmesenke mit einer Temperatur vorzugsweise im Millikelvinbereich haben, umfassen eine schwache Konzentration von paramagnetischen Ionen in einem magnetischen Feld. Als derartige Ionen werden vorteilhafterweise Ionen von seltenen Erden, wie beispielsweise von Erbium (Er³⁺), verwendet. Wenn ein kleiner Energiebetrag, beispielsweise durch elektromagnetische Strahlung, in einem derartigen Sensor deponiert wird, verursacht der Temperaturanstieg eine Änderung der Magnetisierung des von den paramagnetischen Ionen gebildeten Paramagneten, die beispielsweise unter Verwendung einer Spule, die an einen Eingang eines SQUIDs angeschlossen ist, gemessen werden kann. Vorteilhafterweise ist an das magnetische Bolometer ein Absorber thermisch gekoppelt.

Das zu kühlende Objekt kann ferner eine Vielzahl von Sensoren aufweisen. Dies ist beispielsweise vorteilhaft, wenn zwei verschiedenartige Sensoren verwendet werden, deren Energieauflösung in jeweils verschiedenen Energiebereichen unterschiedlich gut ist.

### Kurzbeschreibung der Zeichnung

Weitere Einzelheiten, Merkmale und Vorteile der Erfindung ergeben sich aus der nachfolgenden Beschreibung bevorzugter Ausführungsformen anhand der Zeichnung.

Es zeigen:
Figur 1 eine schematische Schnittansicht von der Seite einer erfindungsgemäßen Kühlvorrichtung gemäß einer ersten Ausführungsform;
Figur 2 eine schematische Schnittansicht von der Seite einer erfindungsgemäßen Kühlvorrichtung gemäß einer zweiten Ausführungsform;
Figur 3 eine schematische Schnittansicht von der Seite einer erfindungsgemäßen Kühlvorrichtung gemäß einer dritten Ausführungsform;
Figur 4 eine schematische Schnittansicht von der Seite einer erfindungsgemäßen Kühlvorrichtung gemäß einer vierten Ausführungsform;
Figur 5 eine schematische Schnittansicht von der Seite einer erfindungsgemäßen Kühlvorrichtung gemäß einer fünften Ausführungsform;
Figur 6 eine schematische Schnittansicht von der Seite einer erfindungsgemäßen Kühlvorrichtung gemäß einer sechsten Ausführungsform;
Figur 7 eine schematische Schnittansicht von der Seite einer erfindungsgemäßen Kühlvorrichtung gemäß einer siebten Ausführungsform;
Figuren 8 eine schematische Darstellung eines erfindungsgemäßen zweistufigen Pulsröhrenkühlers gemäß einer achten Ausführungsform, wobei Figur 8a eine schematische Schnittansicht von der Seite und Figur 8b eine schematische Schnittansicht von oben der Kühlvorrichtung darstellt;
Figur 9 eine schematische Schnittansicht von oben eines erfindungsgemäßen zweistufigen Pulsröhrenkühlers gemäß einer neunten Ausführungsform, wobei hierbei die Anordnung eines auf einem Kühlfinger angeordneten Sensors veranschaulicht werden soll;
Figur 10 eine schematische Darstellung eines Pulsröhrenkühlers gemäß einer ersten Ausgestaltung;
Figur 11 eine schematische Darstellung eines Pulsröhrenkühlers gemäß einer zweiten Ausgestaltung;
Figur 12 eine schematische Darstellung eines Pulsröhrenkühlers gemäß einer dritten Ausgestaltung;
Figur 13 eine schematische Darstellung eines Pulsröhrenkühlers gemäß der dritten Ausgestaltung in einer konkreteren Darstellung als in Figur 12; und
Figur 14 eine schematische Darstellung eines zweistufigen Pulsröhrenkühlersystems mit den wichtigstem Komponenten.

### Bevorzugte Ausführungsformen

Im folgenden wird eine Kühlvorrichtung gemäß der vorliegenden Erfindung anhand bevorzugter Ausführungsformen beschrieben.

### Erste Ausführungsform

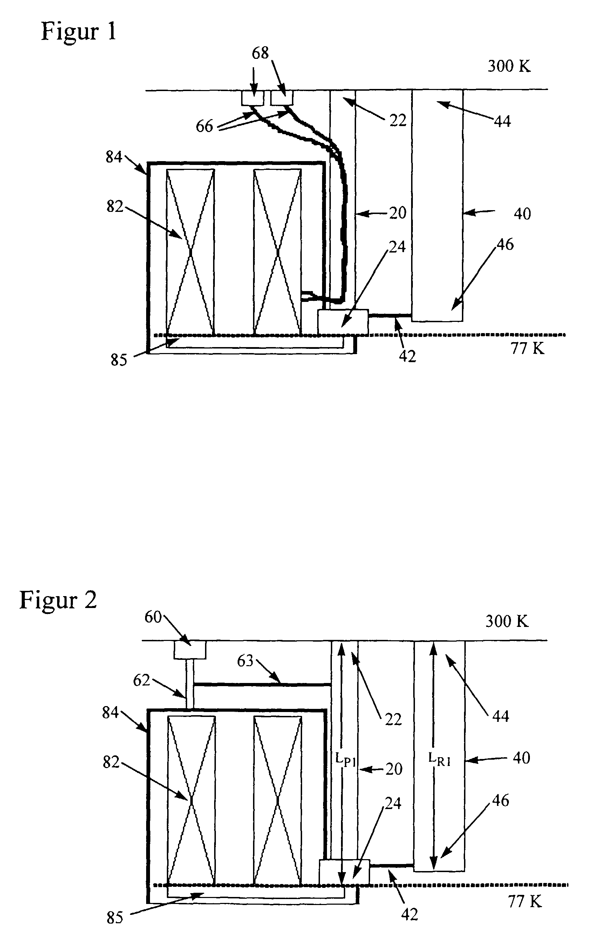

Es sei dabei zunächst auf Figur 1 verwiesen, die eine schematische Darstellung einer ersten Ausführungsform einer erfindungsgemäßen Kühlvorrichtung zeigt. Hier, wie in den folgenden Figuren, werden gleiche Teile mit gleichen Bezugszeichen bezeichnet.

Die erfindungsgemäße Kühlvorrichtung ist vorteilhafterweise zur Verbesserung der Kühlleistung in einem Kühlbehälter bzw. einem Kryostaten angeordnet, wobei die in den Figuren dargestellten Temperaturniveaus (300K, 77K, 4K) Bereiche repräsentieren, die vorteilhafterweise von Wärme- bzw. Strahlungsschilden zur Wärmeisolierung umgeben sind.

Von oben nach unten betrachtet sind an einer Abdeckung des Kryostaten, die aufgrund des thermischen Kontakts mit dem Äußeren des Kryostaten bzw. Kühlbereichs das 300 K-Temperaturniveau (bzw. die in der Einleitung genannten Temperaturen T_{A1}, T_{V}) repräsentiert, ein Warmkopf 22 (obwohl der Warmkopf nicht explizit dargestellt ist, wird er durch den mit der Kryostatenabdeckung verbunden Teil des ersten Pulsrohrs 20 repräsentiert) eines ersten Pulsrohrs 20 und ein warmer Endabschnitt 44 eines dazugehörigen ersten Regenerators 40 angeordnet. Das Pulsrohr 20 und der Regenerator 40 sind im wesentlichen parallel und in Richtung der Erdschwerkraft angeordnet. Am unteren Ende des Pulsrohrs ist ein Kaltkopf 24 vorgesehen, an dem Wärme von einem zu kühlenden Objekt 82, in diesem Fall von einem Magnet 82, bei einer Temperatur von etwa 77K (bzw. T_{E}) aufgenommen wird. Die Wärmeleitung erfolgt dabei über eine Wärmeübertragungseinrichtung 85, die beispielsweise von einer Metallplatte mit guter Wärmeleitung gebildet wird. Ferner ist der Kaltkopf 24 des ersten Pulsrohrs 20 über eine Leitung 42 mit einem kalten Endabschnitt 46 des Regenerators 40 verbunden. Zur thermischen Isolierung bzw. zur Isolierung von Strahlung und Feldern (beispielsweise Magnetfeldern) ist ein Schild 84 vorgesehen. Weitere für den Betrieb eines Pulsröhrenkühlers wichtige Komponenten, die zur Veranschaulichung der Erfindung nicht notwendig sind, werden unten bei der allgemeinen Beschreibung des Funktionsprinzips eines Pulsröhrenkühlers dargestellt.

Wie es anhand der Figur zu erkennen ist, ist gemäß der vorliegenden Erfindung das zu kühlende Objekt neben und zumindest teilweise innerhalb der Länge des ersten Pulsrohrs 20 bzw. des ersten Regenerators 40 angeordnet, wodurch der Kühlbereich innerhalb des Kryostaten optimal ausgenutzt wird, und somit ein kompakter Aufbau der gesamten Kühlvorrichtung erreicht wird.

Es sei bemerkt, daß die angegebenen Temperaturniveaus zur Veranschaulichung dienen und entsprechend dem vorherrschenden Betriebszustand oder der Betriebsart bzw. abhängig von der Umgebungstemperatur andere Werte aufweisen können.

Vorteilhafterweise verlaufen elektrische Zuleitungen 66 für den Magnet 82, die eine Einrichtung zwischen einer mit dem Äußeren des Kühlbereichs in thermischen Kontakt stehenden Anschlußeinrichtung 68 bzw. der Kryostatenabdeckung und dem Magnet 82 bilden, teilweise bzw. über eine vorbestimmte Strecke in thermischem Kontakt entlang des Pulsrohrs 20 in Richtung vom Warmkopf 22 zum Kaltkopf 24. Durch ein nicht dargestellte Durchgangsausnehmung am Schild 84, die vorteilhafterweise abgedichtet ist, treten die elektrischen Zuleitungen 66 in das Innere des Schilds 84, wo sie dann zur Bereitstellung von elektrischem Strom an den Magnet 82 angeschlossen werden. Durch das Führen der elektrischen Zuleitungen 66 zumindest teilweise in thermischem Kontakt mit dem Pulsrohr 20 werden diese schon vor dem Kontakt mit dem Magnet 82 bzw. dem Schild 84 bzw. dem ersten Kaltkopf 24 vorgekühlt, was zu einer geringeren Wärmelast auf den ersten Kaltkopf 24 führt.

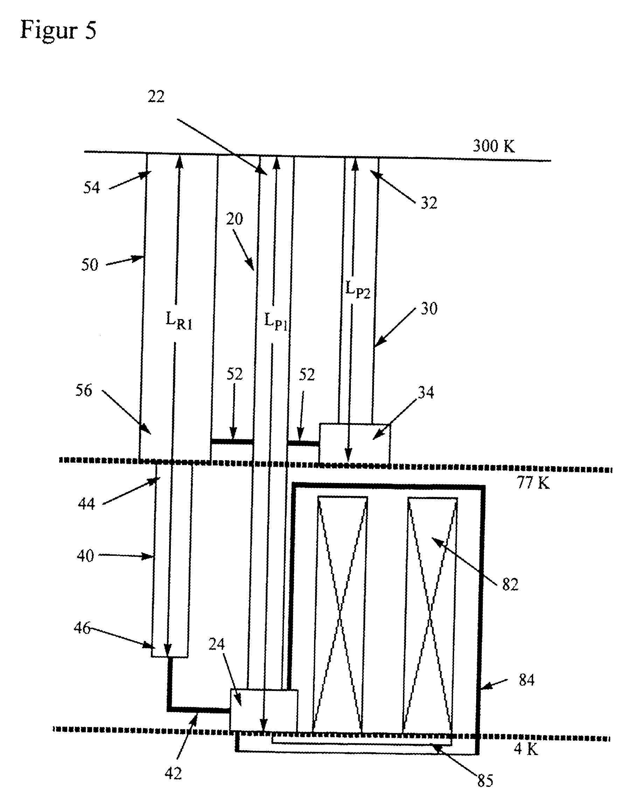

Die elektrischen Zuleitungen 66, die in den folgenden Ausführungsformen aus Gründen der einfacheren und übersichtlichen Darstellung nicht mehr gezeigt sind, sind aus supraleitenden (supraleitend bedeutet hierbei sowohl hochtemperatur- sowie tieftemperatursupraleitend) und/oder normalleitenden Drähten hergestellt, die vorteilhafterweise elektrisch isoliert sind. Anstelle die elektrische Zuleitung in thermischem Kontakt mit einem Pulsrohr zu führen, können sie auch in thermischem Kontakt mit einem Regenerator geführt werden. Der thermische Kontakt der Zuleitungen 66 mit dem Pulsrohr 20 (oder auch 30, das beispielsweise in Figur 5 gezeigt ist) kann durch Aufkleben der Zuleitungen 66 an das Pulsrohr 20 (30) bzw. den Regenerator 40 (50) oder durch Wickeln der Zuleitungen 66 um diese Komponenten 20,40 (30,50) erfolgen. Es ist ferner möglich die Zuleitungen über eine bestimmte Strecke mit Schellen oder dergleichen an den Komponenten 20,40 (30,50) zu befestigen.

### Zweite Ausführungsform

Es sei nun auf Figur 2 verwiesen, die eine schematische Darstellung einer zweiten Ausführungsform der erfindungsgemäßen Kühlvorrichtung zeigt.

Wie in der ersten Ausführungsform steht in der zweiten Ausführungsform der Warmkopf 22 des ersten Pulsrohrs 20 und der warme Endabschnitt 44 des zugehörigen ersten Regenerators 40 in thermischem Kontakt mit dem 300 K-Temperaturniveau. Am unteren Ende des Pulsrohrs 20 ist wieder der Kaltkopf 24 vorgesehen, an dem eine Kühltemperatur über die Wärmeübertragungseinrichtung 85 an dem Magnet 82 von etwa 77K bereitgestellt wird. Ferner ist der Kaltkopf 24 des ersten Pulsrohrs 20 über die Leitung 42 mit einem kalten Endabschnitt 46 des Regenerators 40 verbunden.

Wiederum ist erfindungsgemäß das zu kühlende Objekt zumindest teilweise neben und zumindest teilweise innerhalb der Länge L_{P1} des ersten Pulsrohrs 20 bzw. zumindest teilweise innerhalb der Länge L_{R1} des ersten Regenerators 40 angeordnet, wodurch ein kompakter Aufbau der Kühlvorrichtung erreicht wird. Die Längen L_{P1} und L_{R1} werden zur besseren Übersichtlichkeit nur in dieser Figur 2 eingezeichnet, sie sind jedoch auch auf die anderen Figuren 1 bis 4 zu übertragen.

Zusätzlich zur ersten Ausführungsform ist in der zweiten Ausführungsform eine Stützeinrichtung bzw. Befestigungseinrichtung 62,63 zum Halten des zu kühlenden Objekts 82 bzw. des Schilds 84 vorgesehen. Diese Befestigungseinrichtung 62,63 ist zur Verringerung der Wärmelast auf den Kaltkopf 24 aus zwei Teilen, nämlich einem eigentlichen Halteteil 62, dessen eines Ende mit einer an einer Kryostatenabdeckung fest angebrachten und somit mit dem 300 K-Temperaturniveau in thermischem Kontakt stehenden Anschlußeinrichtung 60 und dessen anderes Ende mit dem Schild 84 verbunden ist, und einem Kontaktteil 63 zur Herstellung eines thermischen Kontakts zwischen dem Halteteil 62 und dem Pulsrohr 20 ausgebildet. Zur Wärmeisolation des zu kühlenden Objekts bzw. Magnets 82 von dem 300K-Temperaturniveau besteht das Halteteil 62 vorteilhafterweise aus einem schlecht wärmeleitendem Material, wie beispielsweise Kunststoff, insbesondere Glasfasern oder Kevlarfäden. Für eine stabile Halterung von schweren zu kühlenden Objekten können auch stangen- oder rohrförmige Halteteile, insbesondere aus schlecht wärmeleitenden Materialien verwendet werden. Zur thermischen Ankopplung an das Pulsrohr 20 jedoch ist vorteilhafterweise für das Kontaktteil 63 ein thermisch gut leitendes Material, wie Metall, in Form von Drähten, Stangen, Rohren, etc. zu verwenden. Aufgrund dieser Befestigungsanordnung wird die Halteeinrichtung 62,63 schon vor dem Kontakt mit dem Magnet 82 vorgekühlt, was zu einer geringeren Wärmelast auf den Kaltkopf 24 führt.

Der thermische Kontakt der Halte- bzw. Kontaktteile 62 und 63 untereinander bzw. mit dem Pulsrohr 20 oder, was auch denkbar ist, mit dem Regenerator 40 kann durch Zusammenkleben der Halte- bzw. Kontaktteile 62 und 63 untereinander bzw. durch Aufkleben an das Pulsrohr 20 oder den Regenerator 40, oder durch Wickeln der Kontaktteile 63 um die Komponenten 20,40 oder 62 erfolgen. Es ist ferner möglich, Schellen oder dergleichen zur Befestigung zu verwenden.

### Dritte Ausführungsform

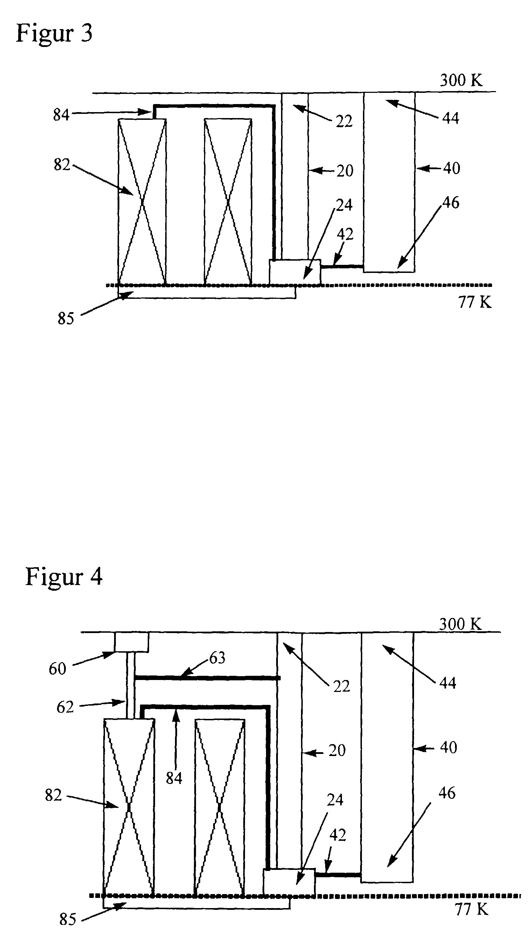

Es sei nun auf Figur 3 verwiesen, die eine schematische Darstellung einer dritten Ausführungsform der erfindungsgemäßen Kühlvorrichtung zeigt.

Die dritte Ausführungsform entspricht dabei im wesentlichen der ersten Ausführungsform, wobei Unterschiede in der Anordnung des 4K-Schilds 84 bestehen. Der Schild 84 umschließt hier im Gegensatz zur ersten Ausführungsform nicht vollständig das eigentliche zu kühlende Objekt, d.h. den Magnet 82, sondern es wird ein Teil (in der Figur der linke Teil) des Magneten 82 selbst und die Wärmeübertragungseinrichtung 85 als Schild benutzt. Dies hat zunächst den Vorteil, den Materialaufwand für den Schild und somit das Gewicht bzw. die Masse des zu kühlenden Objekts zu verringern. Neben dem somit erforderlichen geringeren Kühlaufwand kann dazu noch der Aufwand für zusätzliche Verstärkungsmaßnahmen des Pulrohraufbaus zum Halten des Magnets 82 verringert und somit die Konstruktion der gesamten Kühlvorrichtung vereinfacht werden.

### Vierte Ausführungsform

Es sei nun auf Figur 4 verwiesen, die eine schematische Darstellung einer vierten Ausführungsform der erfindungsgemäßen Kühlvorrichtung zeigt.

Diese vierte Ausführungsform ist im wesentlichen eine Kombination der zweiten und dritten Ausführungsform. Zum einen wird zusätzlich zu dem Schild 84 ein Teil (in der Figur der linke Teil) des Magnets 82 selbst und die Wärmeübertragungseinrichtung 85 als isolierender Schild benutzt. Des weiteren ist eine Stützeinrichtung bzw. Befestigungseinrichtung 62,63 bestehend aus Halteteil 62 und Kontaktteil 63 zum Halten des zu kühlenden Objekts 82 bzw. des Schilds 84 vorgesehen. Dabei ist das eine Ende des Halteteils 62 mit der an der Kryostatenabdeckung angebrachten Anschlußeinrichtung 60 befestigt und das andere Ende mit einem Teil (in der Figur dem linken Teil) des Magnets 82 verbunden. Zum Vorkühlen des Halteteils 62 ist das Kontaktteil 63 zwischen dem Halteteil 62 und dem ersten Pulsrohr 20 angeordnet.

### Fünfte Ausführungsform

Es sei nun auf Figur 5 verwiesen, die eine schematische Darstellung einer fünften Ausführungsform einer erfindungsgemäßen Kühlvorrichtung zeigt, wobei das Kennzeichen dieser Ausführungsform das zweistufige Pulsröhrenkühlersystem ist.

Ähnlich zu den vorangegangenen Ausführungsformen steht in der dieser Ausführungsform ein Warmkopf 22 eines ersten Pulsrohrs 20, ein Warmkopf 32 eines zweiten Pulsrohrs 30, sowie ein warmer Endabschnitt 54 eines zweiten Regenerators 50 in thermischem Kontakt mit dem 300 K-Temperaturniveau (T_{A1}, T_{A2}, T_{V}), beispielsweise einer Kryostatenabdeckung. In dieser Darstellung sind die beiden Regeneratoren 40 und 50 miteinander verbunden, so daß der obere Regenerator 50 als warmer Regeneratorabschnitt 50 bzw. zur Kopplung an das 300K-Temperaturniveau vom Regenerator 40 mit verwendet wird. Es ist jedoch eine Anordnung mit zwei voneinander getrennten Regeneratoren denkbar. Das erste und zweite Pulsrohr 20 und 30, sowie die Regeneratoren bzw. Regeneratorabschnitte 40 und 50 sind im wesentlichen parallel und in Richtung der Erdschwerkraft angeordnet. Am unteren Ende des ersten Pulsrohrs 20 ist ein Kaltkopf 24 vorgesehen, an dem über eine Wärmeübertragungseinrichtung 85, beispielsweise eine Metallplatte, eine Kühltemperatur an einem zu kühlenden Objekt, hier an einem Magnet 82, von etwa 4K (T_{E}) bereitgestellt wird. Am unteren Ende des zweiten Pulsrohrs 30 ist ein Kaltkopf 34 vorgesehen, an dem eine Kühltemperatur von etwa 77K (T_{Z}) zum Vorkühlen des ersten Pulsrohrs 20 bereitgestellt wird. Genauer gesagt, wird die Temperatur von 77K einem den Kaltkopf 24 des ersten Pulsrohrs und den Magnet 82 beinhaltenden Kühlbereich bereitgestellt, der im Fall der Verwendung eines Kryostaten von einem Wärmeschild zur thermischen Isolierung umgeben ist. Ferner ist der Kaltkopf 24 des ersten Pulsrohrs 20 über eine Leitung 42 mit einem kalten Endabschnitt 46 des Regenerators 40 und ist der Kaltkopf 34 des zweiten Pulsrohrs 30 über eine Leitung 52 mit einem kalten Endabschnitt 56 des zweiten Regenerators 50 verbunden. Es sei bemerkt, daß keine Verbindung der Leitung 52 zum Pulsrohr 20 besteht, wie es vielleicht aus der Figur zu entnehmen ist. Dies gilt auch für die folgenden Figuren.

Wie es anhand der Figur zu erkennen ist, ist gemäß der vorliegenden Erfindung das zu kühlende Objekt 82 zumindest teilweise neben und zumindest teilweise innerhalb der Länge L_{P1} des ersten Pulsrohrs 20 bzw. zumindest teilweise neben und zumindest teilweise innerhalb der Länge L_{R1} des ersten Regenerators 40 und unterhalb bzw. in Verlängerung (der Länge L_{P2}) des zweiten Pulsrohrs 30 angeordnet, wodurch der Kühlbereich innerhalb des Kryostaten optimal ausgenutzt wird, und somit ein kompakter Aufbau der gesamten Kühlvorrichtung erreicht wird.

### Sechste Ausführungsform

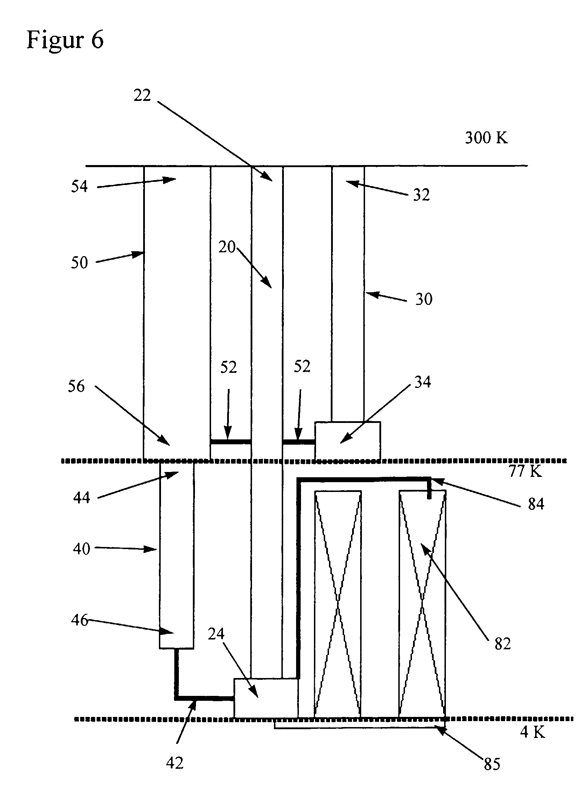

Es sei nun auf Figur 6 verwiesen, die eine schematische Darstellung einer sechsten Ausführungsform der erfindungsgemäßen Kühlvorrichtung zeigt.

Wie bei der fünften Ausführungsform steht in der sechsten Ausführungsform ein Warmkopf 22 eines ersten Pulsrohrs 20, ein Warmkopf 32 eines zweiten Pulsrohrs 30, sowie ein warmer Endabschnitt 54 eines zweiten Regenerators 50 in thermischem Kontakt mit dem 300 K-Temperaturniveau beispielsweise einer Kryostatenabdeckung. Am unteren Ende des ersten Pulsrohrs 20 ist wiederum ein Kaltkopf 24 vorgesehen, an dem eine Kühltemperatur an einem zu kühlenden Objekt, hier an einem Magnet 82, von etwa 4K bereitgestellt wird. Am unteren Ende des zweiten Pulsrohrs 30 ist ein Kaltkopf 34 vorgesehen, an dem eine Kühltemperatur von etwa 77K zum Vorkühlen des ersten Pulsrohrs 20 bereitgestellt wird. Ferner ist der Kaltkopf 24 des ersten Pulsrohrs 20 über eine Leitung 42 mit einem kalten Endabschnitt 46 des Regenerators 40 und ist der Kaltkopf 34 des zweiten Pulsrohrs 30 über eine Leitung 52 mit einem kalten Endabschnitt 56 des zweiten Regenerators 50 verbunden.

Erfindungsgemäß ist das zu kühlende Objekt 82 zumindest teilweise neben und zumindest teilweise innerhalb der Länge des ersten Pulsrohrs 20 bzw. des ersten Regenerators 40 angeordnet. Ferner ist das zu kühlende Objekt 82 unterhalb bzw. in Verlängerung des zweiten Pulsrohrs 30 angeordnet. Dadurch wird ein kompakter Aufbau der gesamten Kühlvorrichtung erreicht.

Ähnlich zur dritten Ausführungsform umschließt der Schild 84 hier nicht vollständig das zu kühlende Objekt bzw. den Magnet 82, sondern es wird einen Teil (in der Figur den rechte Teil) des Magneten 82 selbst und die Wärmeübertragungseinrichtung 85 als Schild benutzt. Dies hat den Vorteil, den Materialaufwand für den Schild und somit das Gewicht bzw. die Masse des zu kühlenden Objekts zu verringern, wodurch wiederum der Aufwand für zusätzliche Verstärkungsmaßnahmen gering gehalten wird.

### Siebte Ausführungsform

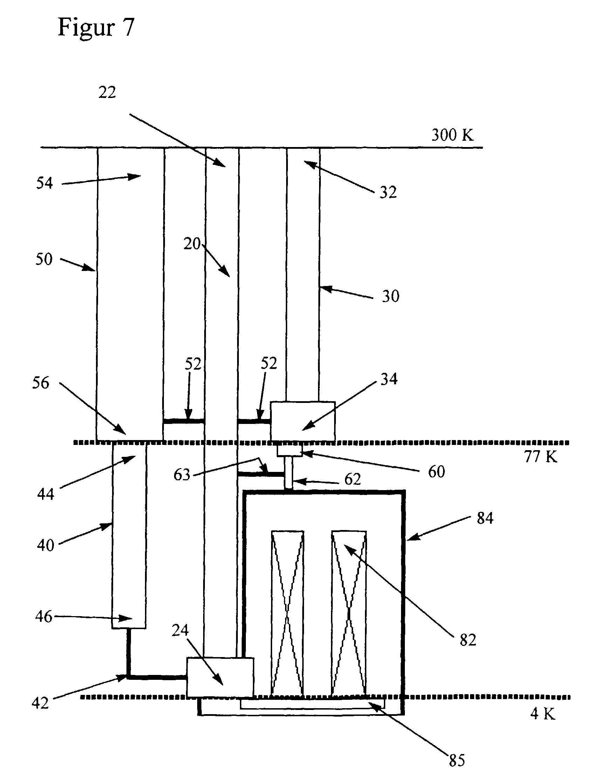

Es sei nun auf Figur 7 verwiesen, die eine schematische Darstellung einer siebten Ausführungsform der erfindungsgemäßen Kühlvorrichtung zeigt.

Diese Ausführungsform entspricht im wesentlichen der sechsten Ausführungsform, wobei zusätzlich eine Stützeinrichtung bzw. Befestigungseinrichtung 62,63 zum Halten des zu kühlenden Objekts 82 bzw. des Schilds 84 vorgesehen ist. Diese Befestigungseinrichtung 62,63 ist zur Verringerung der Wärmelast auf den Kaltkopf 24 aus zwei Teilen, nämlich dem eigentlichen Halteteil 62, dessen eines Ende mit einer an dem zweiten Kaltkopf 34 bzw. an einem 77K-Schild fest angebrachten und somit mit dem 77K-Temperaturniveau in thermischem Kontakt stehenden Anschlußeinrichtung 60 und dessen anderes Ende mit dem Schild 84 verbunden ist, und dem Kontaktteil 63 zur Herstellung eines thermischen Kontakts zwischen dem Halteteil 62 und dem Pulsrohr 20 ausgebildet. Die Materialen für das Halteteil 62 und das Kontaktteil 63 sind entsprechend denjenigen zu wählen, wie sie in der zweiten Ausführungsform genannt sind. Aufgrund dieser Befestigungsanordnung wird die Halteeinrichtung 62,63 schon vor dem Kontakt mit dem Magnet 82 vorgekühlt, was zu einer geringeren Wärmelast auf den Kaltkopf 24 führt.

### Achte Ausführungsform

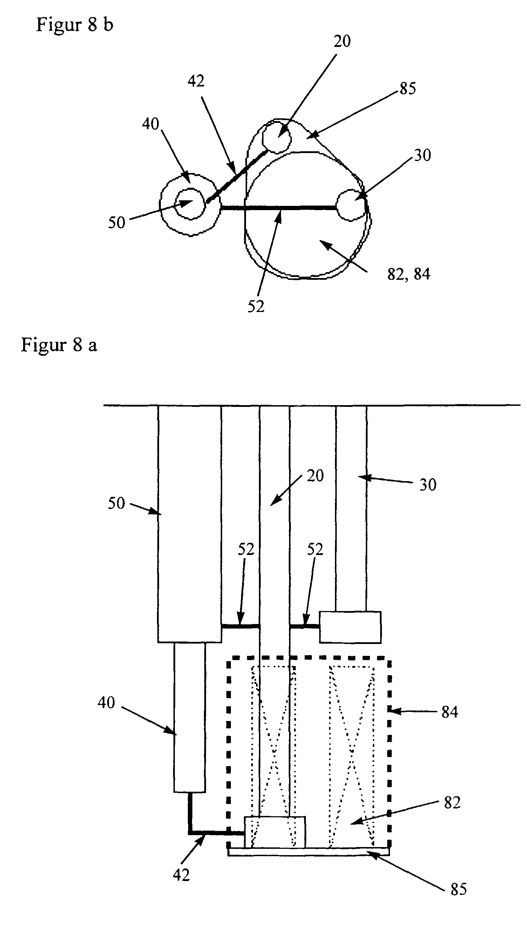

Es sei nun auf die Figuren 8 verwiesen, die eine schematische Darstellung einer achten Ausführungsform der erfindungsgemäßen Kühlvorrichtung zeigen. Hierbei zeigt Figur 8a eine schematische Schnittansicht von der Seite und Figur 8b eine schematische Schnittansicht von oben der Kühlvorrichtung.

Die achte Ausführungsform, die im wesentlichen der in Figur 5 dargestellten fünften Ausführungsform entspricht, mit dem Unterschied, daß der Schild 84 (der in Figur 8a zusammen mit dem Magnet 82 durch die gestrichelte Linie dargestellt ist, um hervorzuheben, daß sich diese beiden Komponenten in einer anderen Ebene in Blickrichtung befinden als beispielsweise das erste Pulsrohr 20) nicht den gesamten Magnet 82 umschließt, sondern nur bis zur Wärmeübertragungseinrichtung 85 reicht, dient hauptsächlich dazu, die dreidimensionale Struktur einer erfindungsgemäßen Kühlvorrichtung zu verdeutlichen. Deshalb werden die einzelnen Komponenten, die mit Bezugszeichen versehen sind, nicht mehr näher erläutert, sondern auf die Beschreibung von Figur 5 verwiesen.

Wie es in den Figuren 8 zu sehen ist, ist der Magnet 82 derart angeordnet, daß der Raum bzw. Kühlraum in einem Kryostaten, der beispielsweise zylinderförmige Gestalt hat, optimal ausgenutzt ist. So ist der Magnet 82, wie es in Figur 8a gezeigt ist, zum einen zumindest teilweise neben bzw. innerhalb der Länge des ersten Pulsrohrs 20 und des ersten Regenerators 40, sowie unterhalb bzw. in Verlängerung des zweiten Pulsrohrs 30 angeordnet, wodurch die Abmessung in axialer Richtung, d.h. der Rohrachsen der Puls- bzw. Regeratorrohre, minimiert ist. Wie es anhand von Figur 8b gezeigt ist, ist ferner die Abmessung in diametraler Richtung, d.h. beispielsweise von den Regeneratoren 40, 50 zum zweiten Pulsrohr 30 minimiert, da der Magnet innerhalb dieses Durchmessers bzw. dieser Strecke angeordnet ist.

### Neunte Ausführungsform

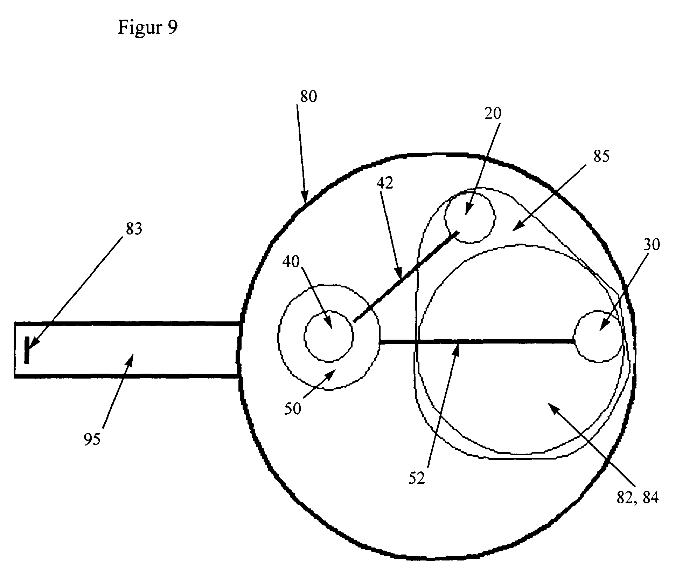

Es sei nun auf Figur 9 verwiesen, die eine schematische Darstellung einer neunten Ausführungsform der erfindungsgemäßen Kühlvorrichtung zeigt. Figur 9 zeigt dabei eine schematische Schnittansicht oben der Kühlvorrichtung.

Die Anordnung der einzelnen Kühlvorrichtungskomponenten, die mit Bezugszeichen versehen sind, entspricht im wesentlichen denen der achten Ausführungsform, weshalb zur Erläuterung dieser bereits bekannten Komponenten auf diese Ausführungsform verwiesen wird.

Zusätzlich zur achten Ausführungsform ist hier eine Wand eines zylinderförmigen Kryostaten 80 eingezeichnet, wobei anhand der Figur zu erkennen ist, daß der Platz innerhalb des Kryostaten 80 in diametraler Richtung bestmöglich ausgenutzt ist.

Ferner zeigt die neunte Ausführungsform eine vorteilhafte Anordnung eines Sensorsystems mit einem auf einem Tieftemperatureffekt basierenden Sensor und einer dafür vorgesehenen Entmagnetisierungsstufe. Die Entmagnetisierungsstufe weist dabei einen Magnet 82 auf, der ein Salz in einer Salzpille (nicht dargestellt) magnetisiert. Die Salzpille ist über einen Kühlfinger, der in einem rohrartigen Fortsatz 95 des Kryostaten 80 angeordnet ist, an einen Tieftemperatursensor 83 thermisch gekoppelt. Das heißt, um Störungen von dem Magnet 82 auf den Sensor 83 zu verhindern, ist der "Rüssel" 95 des Kryostaten 80 mit dem Kühlfinger 95 derart angeordnet, daß der Sensor 83 die maximale Entfernung vom Magnet 82 hat. Wenn somit der Magnet 82 aufgrund der Kopplung über die Wärmeübertragungseinrichtung 85 an den ersten Kaltkopf 24 azentrisch bezüglich des Kryostaten 80 angeordnet ist, dann ist der beste Ort für den Sensor 83 auf der Seite, wo der Magnet 82 den größten Abstand von der Außenwand hat. Somit ist trotz des kompakten Aufbaus der Kühlvorrichtung ein ausreichender Schutz des Sensors 83 vor Störungen seitens des Magnets 28 möglich.

### Pulsröhrenkühler

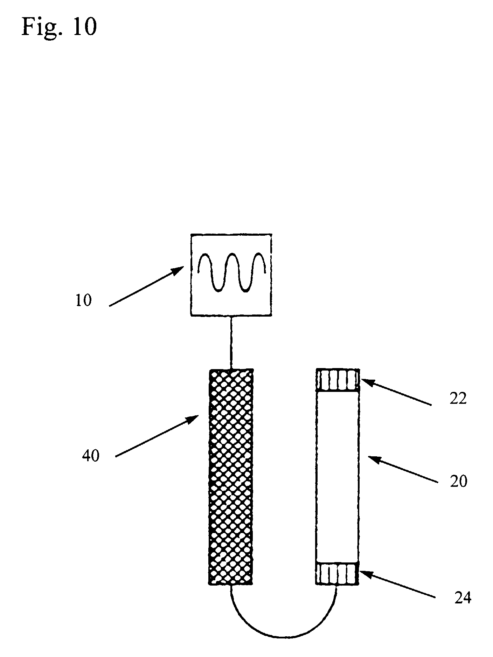

Im folgenden wird der allgemeine Aufbau und die Wirkungsweise eines in der erfindungsgemäßen Kühlvorrichtung zu verwendenden Pulsröhrenkühlers beschrieben. Dabei zeigt Figur 10 eine schematische Darstellung eines Pulsröhrenkühlers gemäß einer ersten Ausgestaltung. Hier, wie in den folgenden Figuren, werden wiederum gleiche Teile mit den gleichen Bezugszeichen bezeichnet.

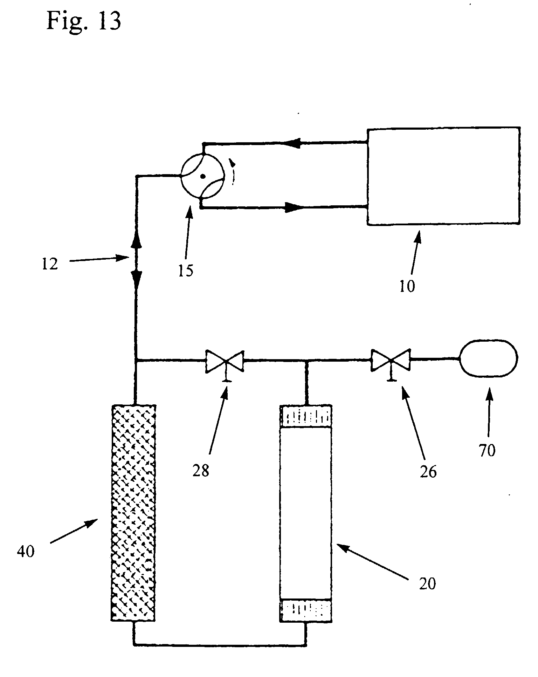

Der Kühleffekt beim Pulsröhrenkühler beruht auf der periodischen Druckänderung und Verschiebung ("Pulsieren") eines Arbeitsgases in einem dünnwandigen Zylinder mit Wärmetauschern an beiden Enden, dem sogenannten Pulsrohr 20. Das Pulsrohr 20 ist mit dem Druckozillator 10 über einen Regenerator 40 verbunden. Der Regenerator 40 dient als Wärmezwischenspeicher, der das vom Druckoszillator 10 einströmende Gas vor Eintritt in das Pulsrohr 20 abkühlt und anschließend das ausströmende Gas wieder auf Raumtemperatur erwärmt. Für diesen Zweck ist er vorteilhafterweise mit einem Material hoher Wärmekapazität gefüllt, das einen guten Wärmeaustausch mit dem strömenden Gas bei gleichzeitig geringem Durchflußwiderstand aufweist. Bei Temperaturen oberhalb 30 K verwendet man Stapel von feinmaschigern Edelstahl- oder Bronzesieben als Regeneratorfüllung. Für tiefere Temperaturen setzt man aus Gründen der hohen Wärmekapazität Bleischrot und neuerdings auch magnetische Materialien, z.B. Er-Ni-Legierungen, ein. Zur Erzeugung der Druckoszillation wird, wie es in Figur 13 gezeigt ist, ein Kompressor 10 in Kombination mit einem nachgeschalteten Rotationsventil 15 verwendet, das periodisch die Hoch- und Niederdruckseite des Kompressors mit dem Kühler verbindet. Alternativ dazu kann die Druckoszillation direkt über die Kolbenbewegung eines ventillosen Kompressors erzeugt werden.

In der ersten Ausgestaltung des Pulsröhrenkühlers ist das Pulsrohr am warmen Ende 22 geschlossen. Der Kühlprozeß läuft qualitativ wie folgt ab: In der Kompressionsphase strömt das im Regenerator 40 vorgekühlte Gas in das Pulsrohr 20 ein. Durch die Druckerhöhung wird das Gas im Pulsrohr 20 erwärmt und gleichzeitig zum warmen Wärmetauscher 22 bzw. Warmkopf 22 hin verschoben, wo ein Teil der Kompressionswärme an die Umgebung abgeführt wird. Durch die anschließende Expansion erfolgt eine Abkühlung des Gases im Pulsrohr 20. Das Gas, welches das Pulsrohr 20 verläßt, ist kälter als beim Eintritt und kann daher Wärme aus dem kalten Wärmetauscher 24 bzw. Kaltkopf 24 und dem zu kühlenden Objekt bzw. einer weiteren Kühleinrichtung, aufnehmen. Eine genauere Analyse des Prozesses in dieser Ausführungsform zeigt, daß für den Wärmetransport vom kalten 24 zum warmen 22 Ende ein Wärmeaustausch zwischen Gas und Rohrwandung erforderlich ist ("Oberflächenwärmepumpen"). Da der Wärmekontakt jedoch nur in einer dünnen Gasschicht an der Rohrwandung erfolgt, ist dieser Kühlprozeß noch nicht optimiert.

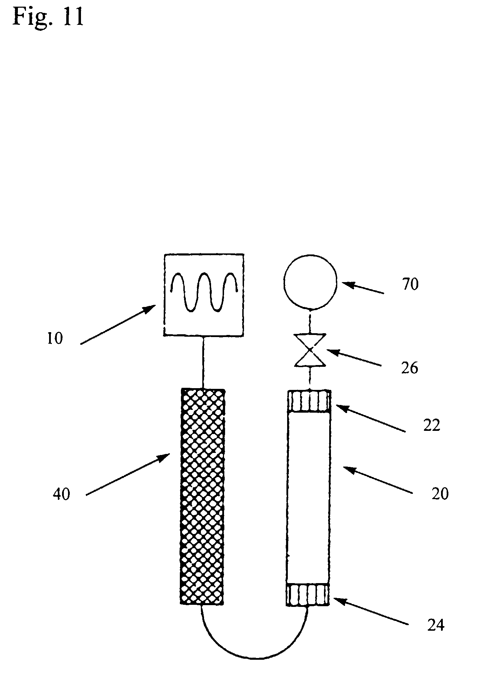

Figur 11 zeigt nun eine schematische Darstellung eines Pulsröhrenkühlers 20 gemäß einer zweiten Ausgestaltung. Hierbei ergibt sich eine wesentliche Steigerung der Effektivität durch den Anschluß eines Ballastvolumens 70 über einen Strömungswiderstand (Nadelventil) 26 am warmen Wärmetauscher 22. Zum einen strömt hier mehr Gas durch den warmen Wärmetauscher 22, das dort dann Kompressionswärme abgeben kann. Zum anderen leistet das Gas im Pulsrohr 20 Arbeit beim Verschieben von Gas in das Ballastvolumen 70, wodurch ein wesentlich höherer Kühleffekt erreicht wird.

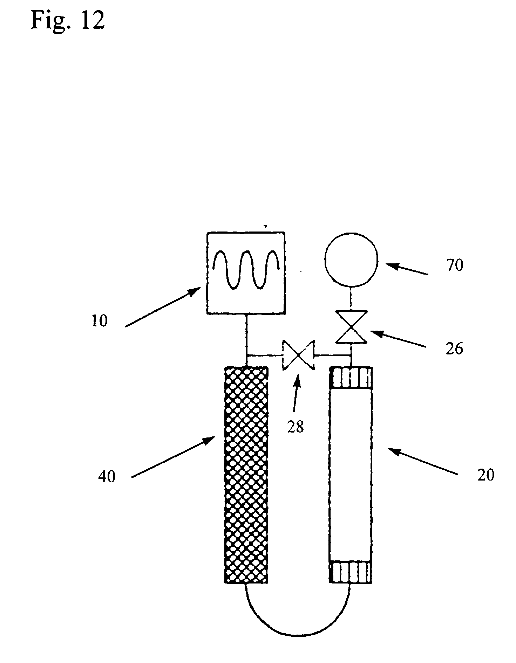

Figur 12 zeigt eine schematische Darstellung eines Pulsröhrenkühlers gemäß einer dritten Ausgestaltung, bei der sich die Effektivität des Kühlers sich weiter steigern läßt, indem der Anteil des Gasflusses, der zur Druckänderung im warmen Teil des Pulsrohres 20 nötig ist, durch einen zweiten Einlaß am warmen Ende geleitet wird. Da dieser Gasfluß nicht mehr den Regenerator 40 passiert, werden die Verluste im Regenerator 40 verringert. Außerdem stellt sich bei einem zweitem Einlaß (mit einem Ventil 28) eine für die Kühlung günstigere zeitliche Abfolge von Druck- und Flußvariation ein.

Figur 13 zeigt einen schematischen Gesamtaufbau eines Pulsröhrenkühlers gemäß der dritten Ausgestaltung in einer konkreteren Darstellung als in Figur 11. Dabei speist in diesem System ein kommerzieller Helium-Kompressor 10 ein motorgetriebenes Rotationsventil 15, das zur Steuerung das Heliumgasstromes dient.

Zur mechanischen Entkopplung und zur Reduzierung von elektromagnetischen Störungen können der eigentliche Kühler und das Rotationsventil über eine flexible Kunststoffleitung 12 miteinander verbunden.

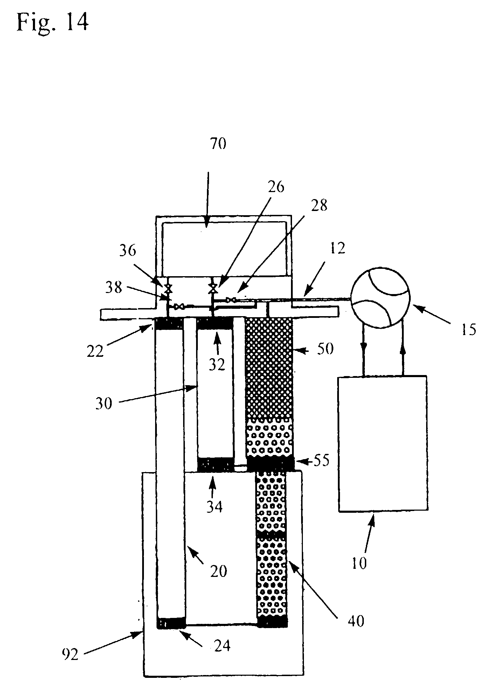

Figur 14 zeigt eine schematische Darstellung eines zweistufiges Pulsröhrenkühlersystem mit den wichtigstem Komponenten, wie es beispielsweise für die dritte bzw. vierte Ausführungsform der erfindungsgemäßen Kühlvorrichtung verwendbar ist. Zur Erzeugung von Druckoszillationen ist ein Kompressor 10 an ein Rotationsventil 15 gekoppelt. Eine Leitung 12 verbindet das Rotationsventil 15 mit dem Pulsröhrenkühlersystem. Dieses weist einen Regenerator 40 der ersten Stufe und einen Regenerator 50 der zweiten Stufe auf, wobei zwischen diesen ein Flußausrichter ("flow straightener") 45 angeordnet ist. Es ist auch denkbar, eine andere Regeneratoranordnung zu wählen, bei der beispielsweise zwei getrennte Regeneratoren verwendet werden. Ferner weist das Pulsröhrenkühlersystem ein erstes Pulsrohr 20 mit einem warmen Wärmetauscher 22 und einem kalten Wärmetauscher bzw. Kaltkopf 24 und ein zweites Pulsrohr 30 mit einem warmen Wärmetauscher 32 und einem kalten Wärmetauscher bzw. Kaltkopf 34 auf. Die jeweiligen warmen Wärmetauscher 22 und 32 sind über Drosselventile, beispielsweise in der Form von Nadelventilen 26 und 36, mit einem gemeinsamen Ballastbehälter bzw. Ballastvolumen 70 verbunden. Es ist ferner denkbar, daß anstelle des gemeinsamen Ballastvolumens zwei getrennte Ballastvolumina verwendet werden. Außerdem sind an den jeweiligen warmen Wärmetauschern 22 und 32 Ventile 38 und 28 für einen zweiten Einlaß vorgesehen. Der Kaltkopf 24 des zweiten Pulsrohrs 30 kühlt dabei einen von einem Wärme- bzw. Strahlungsschild 92 umgebenen Bereich bis auf ungefähr maximal 50 K vor, während am Kaltkopf 24 des ersten Pulsrohrs 20 eine Temperatur von ungefähr 2,2 bis 4,2 K bereitgestellt wird (vgl. dazu C. Wang et al.:"A two-stage pulse tube cooler operating below 4 K", Cryogenics 1997, Volume 37, Nr. 3).

Die erfindungsgemäße Kühlvorrichtung, die Pulsröhrenkühler aufweist, ist aufgrund der fehlenden beweglichen Teile sehr vibrationsarm und deshalb auch besonders gut für die Kühlung von empfindlichen Sensoren wie SQUIDs geeignet.

### Bezugszeichenliste

- 10: Kompressor
- 12: Leitung vom Kompressor weg
- 15: Rotationsventil
- 20: Pulsrohr, erstes Pulsrohr
- 22: warmer Wärmetauscher von 20
- 24: kalter Wärmetauscher, Kaltkopf von 20
- 26: Strömungswiderstand, Nadelventil zu 70
- 28: Ventil des zweiten Einlasses
- 30: zweites Pulsrohr
- 32: warmer Wärmetauscher von 30
- 34: kalter Wärmetauscher, Kaltkopf von 30
- 36: Strömungswiderstand, Nadelventil zu 70
- 38: Ventil des zweiten Einlasses
- 40: Regenerator, Regenerator der ersten Stufe
- 42: Leitung von 46 zu 24
- 44: warmer Endabschnitt von 40
- 46: kalter Endabschnitt von 40
- 50: Regenerator der zweiten Stufe
- 52: Leitung von 56 zu 34
- 54: warmer Endabschnitt von 50
- 55: Flußausrichter zwischen 40 und 50
- 56: kalter Endabschnitt von 50
- 60: Anschlußeinrichtung für 62
- 62: Befestigungseinrichtung
- 64: thermische Abfangeinrichtung
- 66: elektrische Zuleitungen
- 68: Anschlußeinrichtung für 66
- 70: Ballastvolumen
- 80: Kryostat
- 82: Magnet, zu kühlendes Objekt
- 83: Sensor, zu kühlendes Objekt
- 84: Schild, 4K-Schild
- 85: Wärmeübertragungseinrichtung
- 95: Kühlfinger, "Rüssel" von 80
- L_{P1},L_{P2}: Länge des ersten,zweiten Pulsrohrs
- L_{R1},L_{R2}: Länge des ersten,zweiten Regenerators

## Patentansprüche

1. Kühlvorrichtung, die aufweist:
einen ersten Pulsröhrenkühler mit
einem ersten Pulsrohr (20) mit einer Länge (L_{P1}), das einen Warmkopf (22) mit einer ersten Temperatur (T_{A1}) und einen Kaltkopf (24) mit einer bezüglich der ersten Temperatur tieferen zweiten Temperatur (T_{E}) aufweist, und
einem ersten Regenerator (40) mit einer Länge (L_{R1}), der einen warmen Endabschnitt (44) und einen kalten Endabschnitt (46), welcher mit dem Kaltkopf (24) des ersten Pulsrohrs (20) verbunden ist, aufweist; und
ein zu kühlendes Objekt (82), das über eine Wärmeübertragungseinrichtung (80) an den Kaltkopf (24) des ersten Pulsrohrs (20) thermisch gekoppelt ist, **dadurch gekennzeichnet**,
daß das zu kühlende Objekt (82) neben und zumindest teilweise innerhalb der Länge (L_{P1}) des ersten Pulsrohrs (20) und/oder der Länge (L_{R1}) des ersten Regenerators (30) angeordnet ist.

2. Kühlvorrichtung nach Anspruch 1, gekennzeichnet durch eine Befestigungseinrichtung (62,63) zum Halten des zu kühlenden Objekts (82) mit einem ersten Ende, das mit dem zu kühlenden Objekt (82) verbunden ist, und einem zweiten Ende, das mit einem Bereich (60), der eine bezüglich der zweiten Temperatur (T_{E}) höhere Temperatur (T_{V}) aufweist, verbunden ist.

3. Kühlvorrichtung nach Anspruch 1 oder 2, dadurch gekennzeichnet, daß das erste Pulsrohr (20) und der erste Regenerator (40) im wesentlichen parallel zueinander angeordnet sind.

4. Kühlvorrichtung nach einem der Ansprüche 1 bis 3, dadurch gekennzeichnet, daß das erste Pulsrohr (20) und der erste Regenerator (40) im wesentlichen vertikal in Richtung des Schwerkraftgradienten angeordnet sind.

5. Kühlvorrichtung nach einem der Ansprüche 1 bis 4, gekennzeichnet durch einen zweiten Pulsröhrenkühler mit
einem zweiten Pulsrohr (30) mit einer im Verhältnis zur Länge (L_{P1}) des ersten Pulsrohrs (20) kleineren Länge (L_{P2}), das einen Warmkopf (32) mit einer dritten Temperatur (T_{A2}) und einen Kaltkopf (34) mit einer bezüglich der dritten Temperatur (T_{A2}) tieferen vierten Temperatur (T_{Z}), die zwischen der ersten Temperatur (T_{A1}) und der zweiten Temperatur (T_{E}) liegt, aufweist, und
einem zweiten Regenerator (50) mit einer im Verhältnis zur Länge (L_{R1}) des ersten Regenerators (40) kleineren Länge (L_{R2}), der einen warmen Endabschnitt (54) und einen kalten Endabschnitt (56), welcher mit dem Kaltkopf (34) des zweiten Pulsrohrs (30) verbunden ist, aufweist,
wobei an dem zweiten Pulsrohr (30) die vierte Temperatur (T_{Z}) zum Vorkühlen des ersten Pulsröhrenkühlers bereitgestellt wird.

6. Kühlvorrichtung nach Anspruch 5, dadurch gekennzeichnet, daß das zweite Pulsrohr (30) und der zweite Regenerator (50) im wesentlichen parallel zueinander angeordnet sind.

7. Kühlvorrichtung nach Anspruch 5 oder 6, dadurch gekennzeichnet, daß das zweite Pulsrohr (30) und der zweite Regenerator (50) im wesentlichen vertikal in Richtung des Schwerkraftgradienten angeordnet sind.

8. Kühlvorrichtung nach Anspruch 6 oder 7, dadurch gekennzeichnet, daß das erste Pulsrohr (20), der erste Regenerator (40), das zweite Pulsrohr (30) und der zweite Regenerator (50) im wesentlichen parallel zueinander angeordnet sind.

9. Kühlvorrichtung nach Anspruch 8, dadurch gekennzeichnet, daß das zu kühlende Objekt (82) in der Verlängerung des zweiten Pulsrohrs (30) und/oder in der Verlängerung des zweiten Regenerators (50) angeordnet ist.

10. Kühlvorrichtung nach einem der Ansprüche 5 bis 9, dadurch gekennzeichnet, daß der erste Regenerator (40) den zweiten Regenerator (50) als seinen warmen Endabschnitt verwendet.

11. Kühlvorrichtung nach einem der Ansprüche 1 bis 10, dadurch gekennzeichnet, daß das zu kühlende Objekt (82) einen Magnet aufweist.

12. Kühlvorrichtung nach einem der Ansprüche 1 bis 10, dadurch gekennzeichnet, daß das zu kühlende Objekt (82) einen Sensor (83) zum Erfassen von Teilchen, Strahlung oder Feldern aufweist.

13. Kühlvorrichtung nach Anspruch 12, dadurch gekennzeichnet, daß der Sensor ein Hochtemperatursupralteiter-SQUID oder ein Tieftemperatursupralteiter-SQUID ist.

14. Kühlvorrichtung nach Anspruch 12, dadurch gekennzeichnet, daß der Sensor ein auf einem Tieftemperatureffekt basierender Sensor ist, der an eine Tieftemperaturkühleinrichtung (85) thermisch gekoppelt ist und von dieser gekühlt wird.

15. Kühlvorrichtung nach Anspruch 14, dadurch gekennzeichnet, daß der Sensor ein Phasenübergangsthermometer, eine supraleitende Tunneldiode, einen Thermistor oder ein magnetisches Bolometer aufweist.

16. Kühlvorrichtung nach einem der Ansprüche 14 bis 15, dadurch gekennzeichnet, daß die Tieftemperaturkühleinrichtung eine Entmagnitisierungsstufe (85) aufweist.

17. Kühlvorrichtung nach einem der Ansprüche 12 bis 16, dadurch gekennzeichnet, daß das zu kühlende Objekt (82) eine Vielzahl von Sensoren aufweist.

18. Kühlvorrichtung nach einem der Ansprüche 2 bis 17, dadurch gekennzeichnet, daß die Befestigungseinrichtung (62,63) zumindest teilweise in thermischem Kontakt mit dem ersten Pulsrohr (20) und/oder teilweise in thermischem Kontakt mit dem ersten Regenerator (40) verläuft.

19. Kühlvorrichtung nach einem der Ansprüche 5 oder 18, dadurch gekennzeichnet, daß die Temperatur (T_{V}) des Bereichs (60) höher als die vierte Temperatur (T_{Z}) liegt, wobei die Befestigungseinrichtung (62,63) zumindest teilweise in thermischem Kontakt mit dem zweiten Pulsrohr (30) und/oder in thermischem Kontakt mit dem zweiten Regenerator (50) verläuft.

20. Kühlvorrichtung nach Anspruch 18 oder 19, dadurch gekennzeichnet, daß die Befestigungsseinrichtung (62,63) zum Halten des zu kühlenden Objekts (82) einen zweiteiligen Aufbau hat, der ein Halteteil (62) zum Halten des zu kühlenden Objekts (82) an einer Anschlußeinrichtung (60), die mit dem Bereich (60) in thermischem Kontakt steht, und ein Kontaktteil (63) zum Herstellen eines thermischen Kontakts zwischen dem Halteteil (62) und dem ersten Pulsrohr (20) und/oder dem ersten Regenerator (40) und/oder dem zweiten Pulsrohr (30) und/oder dem zweiten Regenerator (50) aufweist.

21. Kühlvorrichtung nach Anspruch 20, dadurch gekennzeichnet, daß das Halteteil (62) aus einem schlecht wärmeleitenden Material und das Kontaktteil (63) aus einem gut wärmeleitenden Material besteht.
